# EUROPEAN PATENT APPLICATION

(11) **EP 4 210 096 A1**
(43) Date of publication of application: **12.07.2023**
(21) Application number: 20954573.0
(22) Date of filing: 25.09.2020
(51) Int. Cl.: H01L 23/02

(54) **CHIP AND MANUFACTURING METHOD THEREFOR, AND ELECTRONIC EQUIPMENT**

(71) Applicant: Huawei Technologies Co., Ltd., Shenzhen, Guangdong 518129 (CN)
(72) Inventor: LI, Wei, Shenzhen, Guangdong 518129 (CN); XU, Huilong, Shenzhen, Guangdong 518129 (CN); YAO, Yanlong, Shenzhen, Guangdong 518129 (CN)
(74) Representative: Gill Jennings & Every LLP
(86) International application number: PCT/CN2020/117774
(87) International publication number: WO 2022/061721

(57) **Abstract**

This application provides a chip and a manufacturing method thereof, and an electronic device, and relates to the field of chip technologies, to reduce an impact of an external stress on a semiconductor device inside the chip. The chip includes a substrate, a device layer, a cap, and a sidewall. The semiconductor device is disposed at the device layer, and a trench is disposed around the semiconductor device on a surface of a side that is of the device layer and that faces away from the substrate. The cap and the device layer are oppositely disposed, and the cap is located on the side that is of the device layer and that faces away from the substrate. The sidewall is disposed between the cap and the device layer and is disposed around the semiconductor device. The trench is located on an inner side of the sidewall.

## Description

### TECHNICAL FIELD

This application relates to the field of chip technologies, and in particular, to a chip and a manufacturing method thereof, and an electronic device.

### BACKGROUND

In a chip packaging technology, a surface of a semiconductor device is covered with a plastic packaging material (EMC), to protect a chip from being affected or enable a chip to be less affected (in terms of physics and chemistry) by an external environment and provide a good working condition for the chip, so that the chip has a stable and normal function.

The plastic packaging material is in direct contact with the surface of the semiconductor device, the plastic packaging material shrinks in a curing process. Consequently, a compressive stress is generated on the surface of the semiconductor device. In addition, in a working process of the semiconductor device, the plastic packaging material further generates a thermal stress on the surface of the semiconductor device due to factors such as different thermal expansion coefficients of the device and the plastic packaging material, and a change in an ambient temperature These external stresses may affect performance of the semiconductor device or even cause device failures.

### SUMMARY

Embodiments of this application provide a chip and a manufacturing method thereof, and an electronic device, to reduce an impact of an external stress on a semiconductor device inside the chip.

This application provides a chip, including: a substrate, a device layer, a cap, and a sidewall. A semiconductor device is disposed at the device layer, and a trench is disposed around the semiconductor device on a surface of a side that is of the device layer and that faces away from the substrate. The cap and the device layer are oppositely disposed, and the cap is located on the side that is of the device layer and that faces away from the substrate. The sidewall is disposed between the cap and the device layer and is disposed around the semiconductor device. The trench is located on an inner side of the sidewall.

According to the chip provided in this embodiment of this application, the semiconductor device is disposed in a cavity area formed by the cap and the sidewall, so that a surface of the semiconductor device is isolated from an external environment, and an external stress is prevented from directly acting on the surface of the semiconductor device. In addition, in the cavity area formed by the cap and the sidewall, the trench is disposed at the device layer in the area between the semiconductor device and the sidewall, to cut off a stress transmission path between the outside of the cavity and the semiconductor device, and prevent the external stress from being transferred to the semiconductor device, so that an impact of the external stress on the semiconductor device is reduced.

In some possible implementations, the semiconductor device includes one or more of a piezoelectric device, a piezoresistive device, or a capacitive sensor. Based on stress sensitivity of the piezoelectric device, the piezoresistive device, or the capacitive sensor, the trench is disposed around the semiconductor device, to reduce the impact of the external stress on the semiconductor device, so that performance and normal operation of the semiconductor device can be effectively ensured.

In some possible implementations, the trench includes an annular groove disposed around the semiconductor device to cut off, to a most extent, a transmission path through which the external stress is transferred to the semiconductor device, so that the impact of the external stress on the semiconductor device is effectively reduced.

In some possible implementations, the trench includes a plurality of grooves dispersedly disposed at spacings around the semiconductor device. Effective support is performed on a connection area between two adjacent trenches, to ensure that the chip has a reliable connection strength (that is, reliability) at a position of the trench while the transmission path through which the external stress is transferred to the semiconductor device is cut off by using the trench.

In some possible implementations, a width of the trench is greater than or equal to 0.1 µm, to avoid a case in which the trench cannot effectively prevent the external stress from being transferred to the semiconductor device because the trench is deformed due to a stress in a width direction of the trench and two trench walls are in pressed contact.

In some possible implementations, a trench bottom of the trench is located in the substrate, to ensure that the trench effectively prevents the external stress.

In some possible implementations, the semiconductor device includes an electrode; the chip is provided with a via hole on a side that is of the electrode and that faces away from the cap; and a connecting portion is disposed on a side that is of the substrate and that faces away from the cap, and the connecting portion is connected to the electrode through the via hole. In this case, when packaging is performed on the chip, an upper surface of the cap is usually covered with a plastic packaging material, but a lower surface of the substrate is not covered with the plastic packaging material. Therefore, compared with a case in which the connecting portion is disposed on the upper surface of the cap, by disposing the connecting portion on the lower surface of the substrate, a case in which a stress (such as a thermal stress or a curing shrinkage stress) generated by the plastic packaging material is transferred to the surface of the semiconductor device by using the connecting portion can be effectively avoided.

An embodiment of this application further provides a chip manufacturing method, including:
forming, on a substrate, a device layer including a semiconductor device;
forming, on a surface of the device layer, a trench located around the semiconductor device; and
covering a cap on the device layer by using a sidewall, where the sidewall is disposed around the semiconductor device, and the trench is located on an inner side of the sidewall.

According to the chip manufacturing method provided in this embodiment of this application, the trench is manufactured around the semiconductor device at the device layer, the sidewall and the cap are formed on an outer side of the semiconductor device and the trench at the device layer, and the semiconductor device and the trench are disposed in a cavity formed by the sidewall and the cap. In this case, a surface of the semiconductor device can be isolated from an external environment by using the cavity formed by the sidewall and the cap, to prevent an external stress from directly acting on the surface of the semiconductor device. A stress transmission path between the outside of the cavity and the semiconductor device can be cut off by using the trench, to prevent the external stress from being transferred to the semiconductor device, so that an impact of the external stress on the semiconductor device is reduced.

In some possible implementations, the chip manufacturing method further includes: forming, on a surface of a side that is of the substrate and that faces away from the cap, a via hole corresponding to a position of an electrode in the semiconductor device, and forming a connecting portion connected to the electrode through the via hole. When packaging is performed on the chip, an upper surface of the cap is usually covered with a plastic packaging material, but a lower surface of the substrate is not covered with the plastic packaging material. Therefore, compared with a case in which the connecting portion is disposed on the upper surface of the cap, by forming the connecting portion connected to the electrode of the semiconductor device on the surface of the side that is of the substrate and that faces away from the cap, a case in which a stress (such as a thermal stress, or a curing shrinkage stress) generated by the plastic packaging material is transferred to the surface of the semiconductor device by using the connecting portion is avoided.

In some possible implementations, the covering a cap on the device layer by using a sidewall includes: forming, on a surface of a side that is of the device layer and that faces away from the substrate, a sidewall that is disposed around the semiconductor device and that is located on an outer side of the trench; and covering the cap on the sidewall.

An embodiment of this application further provides an electronic device, including a printed circuit board and the chip according to any one of the foregoing possible implementations. The chip is connected to the printed circuit board.

### BRIEF DESCRIPTION OF DRAWINGS

FIG. 1 is a schematic diagram of a cross-sectional structure of a chip according to an embodiment of this application;
FIG. 2 is a top view of a chip according to an embodiment of this application;
FIG. 3 is a top view of a chip according to an embodiment of this application;
FIG. 4 is a top view of a chip according to an embodiment of this application;
FIG. 5 is a top view of a chip according to an embodiment of this application;
FIG. 6 is a top view of a chip according to an embodiment of this application;
FIG. 7 is a schematic diagram of a structure of a chip according to an embodiment of this application;
FIG. 8a is a schematic diagram of a structure of a chip according to an embodiment of this application;
FIG. 8b is a schematic diagram of a structure of a chip according to an embodiment of this application;
FIG. 9 is a top view or a bottom view of a chip according to an embodiment of this application;
FIG. 10 is a flowchart of a chip manufacturing method according to an embodiment of this application;
FIG. 11 is a schematic diagram of a structure in a chip manufacturing process according to an embodiment of this application;
FIG. 12 is a schematic diagram of a structure in a chip manufacturing process according to an embodiment of this application;
FIG. 13 is a schematic diagram of a structure in a chip manufacturing process according to an embodiment of this application;
FIG. 14 is a schematic diagram of a structure in a chip manufacturing process according to an embodiment of this application;
FIG. 15 is a schematic diagram of a structure in a chip manufacturing process according to an embodiment of this application; and
FIG. 16 is a schematic diagram of a structure in a chip manufacturing process according to an embodiment of this application.

### DESCRIPTION OF EMBODIMENTS

To make the objectives, technical solutions, and advantages of this application clearer, the following clearly describes the technical solutions in this application with reference to the accompanying drawings in this application. It is clear that the described embodiments are a part rather than all of the embodiments of this application. All other embodiments obtained by a person of ordinary skill in the art based on the embodiments of this application without creative efforts shall fall within the protection scope of this application.

In the embodiments, claims, and accompanying drawings of this application of the specification, terms "first", "second", and the like are merely intended for distinguishing and description, and shall not be understood as an indication or implication of relative importance or an indication or implication of an order. Terms such as "connect", "link", or the like are used to express connection or interaction between different assemblies, and may include a direct connection or an indirect connection through another assembly. In addition, the terms "include", "have", and any variant thereof are intended to cover non-exclusive inclusion, for example, include a series of steps or units. Methods, systems, products, or devices are not necessarily limited to those steps or units that are literally listed, but may include other steps or units that are not literally listed or that are inherent to such processes, methods, products, or devices. Terms "upper", "lower", "left", "right", and the like are used only relative to the orientation of the components in the accompanying drawings. These directional terms are relative concepts, are used for relative descriptions and clarifications, and may change accordingly as positions at which the components in the accompanying drawings are placed change.

Some embodiments of this application provide an electronic device. The electronic device includes a chip and other electronic devices connected to the chip, for example, a printed circuit board (PCB). A semiconductor device is disposed inside the chip.

A specific arrangement form of the semiconductor device in the chip is not limited in this application, provided that a working requirement of the electronic device is met. By way of example, the semiconductor device may include a processor logic circuit, a storage circuit, a capacitive sensor, a piezoelectric device, a piezoresistive device, and the like.

A specific form of the electronic device is not limited in the embodiments of this application. For example, the electronic device may be an electronic product such as a mobile phone, a tablet computer, a notebook computer, a vehicle-mounted computer, a smart watch, or a smart band.

According to the electronic device provided in the embodiments of this application, on a surface of a device layer of the semiconductor device disposed inside the chip, a trench is disposed around the semiconductor device, and a transmission path through which an external stress is transferred to the semiconductor device by using the trench is cut off, to reduce an impact of the external stress on the semiconductor device. Especially, for the stress-sensitive semiconductor device, the trench is disposed around the semiconductor device, to reduce the external stress acting on the semiconductor device, so that a normal operation of the electronic device can be effectively ensured. For example, when a plastic packaging material is used to package the chip, the plastic packaging material generates a compressive stress in a curing process. In addition, because thermal expansion coefficients of the semiconductor device inside the chip and the external plastic packaging material are different, a thermal stress is generated when an ambient temperature changes. The trench for the chip in this application is disposed, and the stresses can be prevented from being transferred from the outside to the surface of the semiconductor device inside, so that the purpose of protecting the semiconductor device is achieved, and the normal operation of the electronic device is further ensured.

The following describes a specific arrangement structure of the chip used in the electronic device in the embodiments of this application.

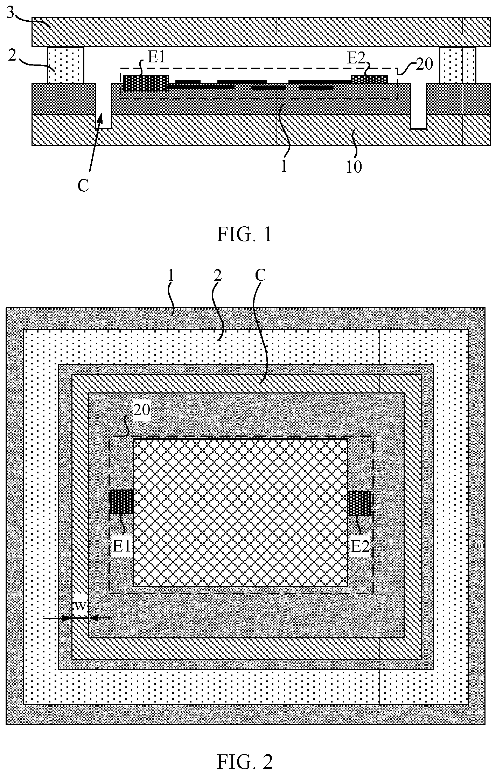

Some embodiments of this application provide a chip. As shown in FIG. 1 (a sectional view) and FIG. 2 (a top view of some components), the chip includes a substrate 10 and a device layer 1 disposed on the substrate 10, where a semiconductor device 20 is disposed in the device layer 1.

By way of example, the substrate 10 may be a glass sheet (that is, a glass substrate), a silicon chip (that is, a Si sheet or a Si wafer), or another sheet that has a similar function and is compatible with a wafer-level packaging process material.

By way of example, the device layer 1 generally includes a plurality of pattern film layers such as a metal layer, a semiconductor layer, and a dielectric layer, and the semiconductor device 20 is formed by using the plurality of pattern film layers.

By way of example, the semiconductor device 20 may be a semiconductor device that is sensitive to a stress. For example, the semiconductor device may be a piezoelectric device such as a surface acoustic wave (SAW) device and a bulk acoustic wave (BAW) device, or may be a piezoresistive device such as a piezoresistive accelerometer, or a capacitive sensor device such as a capacitive accelerometer.

By way of example, the semiconductor device 20 may include an electrode (for example, E1 or E2, but it is not limited thereto), and is connected to an external device (for example, a chip or a PCB) by using the electrode, to implement interconnection and communication between the chip and the external device.

In addition, as shown in FIG. 1 and FIG. 2, in the chip, a trench C is disposed around the semiconductor device 20 on an upper surface (that is, a surface of a side facing away from the substrate 10) of the device layer 1, and a stress transmission path between the outside of the chip and the semiconductor device 20 is cut off by using the trench C, so that an external stress is isolated and an impact of the external stress on the semiconductor device 20 is reduced.

A specific arrangement of the trench C is not excessively limited in this application, provided that the trench C is disposed around the semiconductor device 20.

By way of example, in some possible implementations, to cut off, to the most extent, a transmission path through which an external stress is transferred to the semiconductor device 20, and effectively reduce the impact of the external stress on the semiconductor device, as shown in FIG. 2, the trench C may be an annular groove disposed around the semiconductor device 20. By way of example, an opening of the annular groove may be a circular ring, a rectangular ring, or the like. This is not limited in this application. In practice, the trench may be disposed based on a requirement. For example, the trench C may be adaptively shaped based on an outer contour shape of the semiconductor device 20.

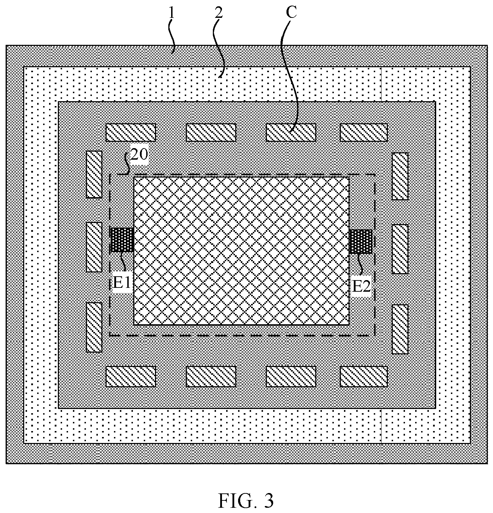

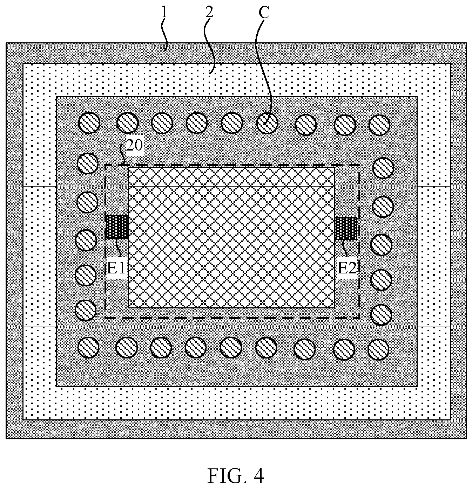

By way of example, in some possible implementations, to ensure that the chip has a reliable connection strength (that is, reliability) at a position of the trench C while the transmission path through which the external stress is transferred to the semiconductor device 20 is cut off by using the trench C, as shown in FIG. 3 and FIG. 4, the trench C may include a plurality of grooves that are dispersedly disposed at spacings around the semiconductor device 20, and the reliability of the chip is ensured by using a connection area between two adjacent trenches C. Specific shapes of the plurality of dispersedly disposed grooves are not limited in this application. For example, the groove may be a strip-shaped groove (as shown in FIG. 3) disposed along an outer contour of the semiconductor device 20, or may be a circular groove (as shown in FIG. 4, that is, a circular hole), or the like. In practice, the groove may be disposed based on a requirement.

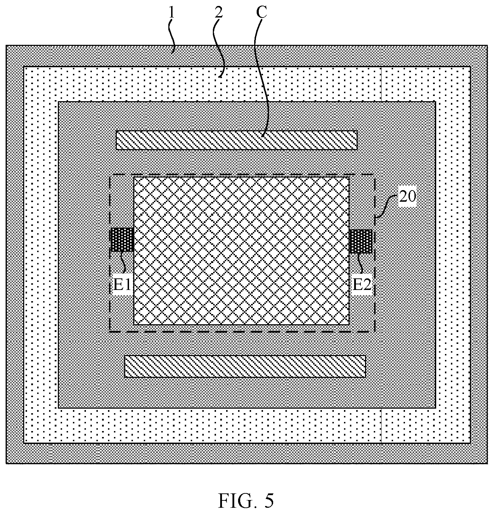

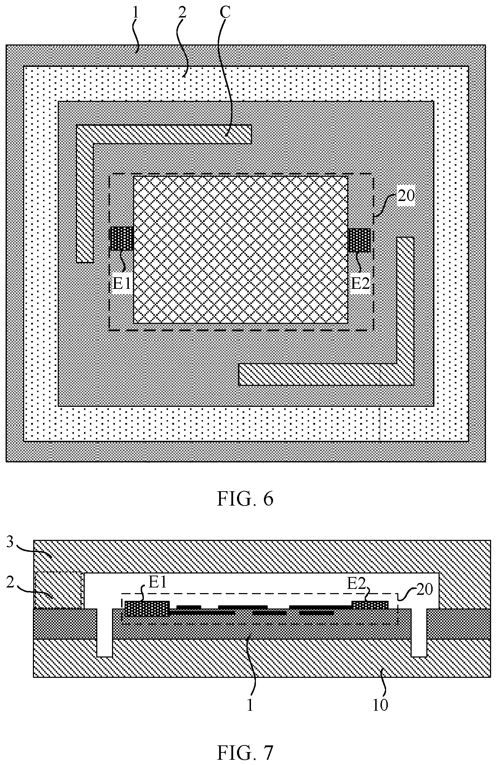

By way of example, in some possible implementations, the trench C may include a groove disposed in a part of a side area of the semiconductor device 20. For example, as shown in FIG. 5 and FIG. 6, the trench C may include grooves disposed in two opposite side areas of the semiconductor device 20. For another example, the trench C may include only a groove disposed in a side area (for example, a left side or a right side) of the semiconductor device 20.

In addition, to prevent a case in which the trench C cannot effectively prevent the external stress from being transferred to the semiconductor device 20 because the trench C is deformed due to a stress in a width direction of the trench C and two trench walls are in pressed contact, in some possible implementations, as shown in FIG. 2, a width w of the trench C may be set to be greater than or equal to 0.1 µm. For example, the width w of the trench C may be set to 10 µm, 20 µm, or 50 µm, to ensure that the transmission path through which the external stress is transferred to the semiconductor device 20 can be effectively cut off by using the trench C. It should be noted herein that the width of the trench C refers to a distance between an edge of a side that is of the trench C and is close to the semiconductor device 20 and a side that is of the trench C and that is away from the semiconductor device 20.

It may be understood herein that a larger width of the trench C indicates better stress isolation effect. However, when a small size requirement for the chip is considered, to avoid an increase in a chip size, in some possible implementations, the width w of the trench C may be set to be less than or equal to 100 µm.

It may be further understood that a larger depth of the trench C indicates better stress isolation effect. A depth size of the trench C is not limited in this application. When it is ensured that the chip has a reliable connection strength (that is, reliability) at a position of the trench C, a depth of the trench C may be increased as much as possible based on a type and a specification of the chip. By way of example, in some possible implementations, as shown in FIG. 1, the depth of the trench C may extend into the substrate 10, that is, a trench bottom of the trench C is located in the substrate 10.

Based on this, as shown in FIG. 1, the chip further includes a cap 3 disposed opposite to the device layer 1, and the device layer 1 and the cap 3 are supported and connected by using a sidewall (wall) 2. As shown in FIG. 2, the sidewall 2 is disposed around the semiconductor device 20, and the trench C is located on an inner side (that is, the trench C is located in an area between the semiconductor device 20 and the sidewall 2) of the sidewall 2. In this case, a cavity is formed between the cap 3 and the sidewall 2, and the semiconductor device 20 is located in a cavity area. In other words, the upper surface of the semiconductor device 20 is isolated from the outside by using the cap 3 and the sidewall 2, so that direct contact between the plastic packaging material and the upper surface of the semiconductor device is avoided during subsequent packaging, and the impact of the external stress on the semiconductor device is reduced.

A case of the sidewall 2 and the cap 3 is as follows.

In some possible implementations, as shown in FIG. 1, the sidewall 2 and the cap 3 may be two independent components. By way of example, the sidewall 2 and the cap 3 may use different materials, and are manufactured by using different processes when the chip is manufactured. For example, the sidewall 2 may use a polymer, and the cap 3 may use a glass sheet, a silicon chip, or another sheet that has a similar function and is compatible with a wafer-level packaging process material.

In some possible implementations, as shown in FIG. 7, the sidewall 2 and the cap 3 may alternatively be an integral connected structure. For example, when the chip is manufactured, the sidewall 2 and the cap 3 may be manufactured by using a same thin sheet (such as a silicon chip).

For related manufacturing of the sidewall 2 and the cap 3, refer to a chip manufacturing method in a subsequent embodiment. Details are not described herein again.

In conclusion, according to the chip provided in this embodiment of this application, the semiconductor device 20 is disposed in the cavity area formed by the cap 3 and the sidewall 2, so that the surface of the semiconductor device 20 is isolated from an external environment, and the external stress is prevented from directly acting on the surface of the semiconductor device 20. In addition, in the cavity area formed by the cap 3 and the sidewall 2, the trench C is disposed at the device layer 1 in the area between the semiconductor device 20 and the sidewall 3, to cut off the stress transmission path between the outside of the chip and the semiconductor device, and prevent the external stress from being transferred to the semiconductor device, so that the impact of the external stress on the semiconductor device is reduced.

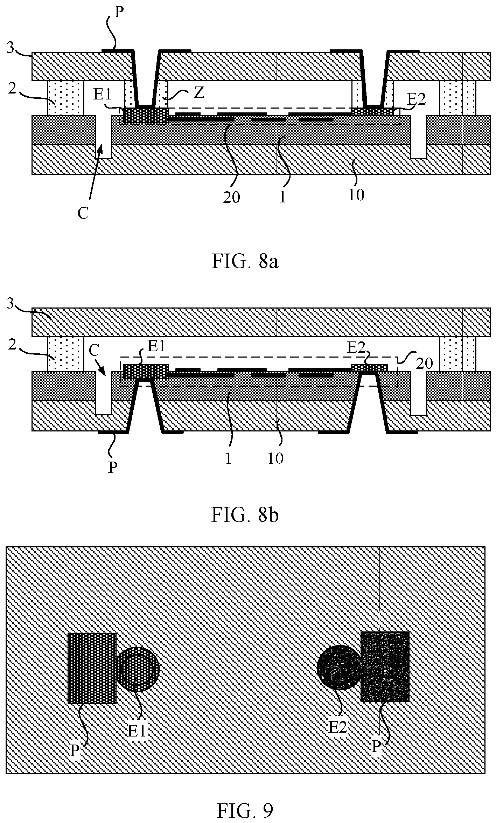

In addition, to ensure that the semiconductor device 20 in the chip can be electrically connected to the external device (such as the chip or the PCB) to implement interconnection and communication, in the chip, connecting portions P (pad) may be disposed on an upper surface (that is, a surface of a side facing away from the substrate 10, as shown in FIG. 8a) of the cap 3, or on a lower surface (that is, a surface of a side facing away from the cap 3, as shown in FIG. 8b) of the substrate 10. The connecting portions P are connected to electrodes (E1 and E2) of the semiconductor device 20 located inside the chip, and an electrical signal is transmitted to the electrodes (E1 and E2) of the semiconductor device 20 by using the connecting portions P, to implement interconnection and communication of the chip. In some possible implementations, as shown in FIG. 8a and FIG. 9 (top views of the chip), support posts Z may be disposed between the electrodes (E1 and E2) of the semiconductor device 20 and the cap 3, via holes are disposed on the support posts Z and the cap 3 at positions corresponding to the electrodes (E1 and E2), and the connecting portions P located on the upper surface of the cap 3 are connected to upper surfaces of the electrodes (E1 and E2) through the via holes. It may be understood herein that the connecting portion P includes a part located on the upper surface of the cap 3 and a part extending into the via hole. Certainly, the part that is of the connecting portion P and that is located on the upper surface of the cap 3 and the part that is of the connecting portion P and that extends into the via hole may be manufactured by using a same manufacturing process, or may be respectively manufactured by using two manufacturing processes. This is not limited in this application.

By way of example, in some possible implementations, the support post Z and the sidewall 2 that are located between the cap 3 and the device layer 1 may be manufactured and processed by using a same film layer, that is, the support post Z and the sidewall 2 are disposed at a same layer and are of a same material, to simplify the process and reduce manufacturing costs.

In some possible implementations, as shown in FIG. 8b and FIG. 9 (bottom views of the chip), via holes may be disposed below the electrodes (E1 and E2) of the semiconductor device 20 (that is, a side facing away from the cap 3), and the connecting portions P located on the lower surface of the substrate 10 are connected to lower surfaces of the electrodes (E1 and E2) through the via holes. It may be understood herein that the connecting portion P includes a part located on the lower surface of the substrate 10 and a part extending into the via hole. Certainly, the part that is of the connecting portion P and that is located on the lower surface of the substrate and the part that is of the connecting portion P and that extends into the via hole may be manufactured in a same manufacturing process, or may be respectively manufactured in two manufacturing processes. This is not limited in this application.

It may be understood herein that when the chip is packaged, the upper surface of the cap 3 is usually covered with the plastic packaging material, but the lower surface of the substrate 10 is not covered with the plastic packaging material. In this case, compared with the case of disposing the connecting portion P on the upper surface of the cap 3, the connecting portion P is disposed on the lower surface of the substrate 10, and a case in which a stress (such as a thermal stress or a curing shrinkage stress) generated by the plastic packaging material is transferred to the surface of the semiconductor device 20 by using the connecting portion P can be effectively avoided.

In addition, to verify that the stress acting on the surface of the semiconductor device 20 can be effectively reduced by disposing the trench C and the cap 3, in this application, actual simulation is performed on changing stresses acting on the surfaces of the semiconductor devices 20 in three different arrangement forms at a same ambient temperature (105°C). The semiconductor devices 20 in the three different forms are respectively as follows: a semiconductor device 20 without a trench C and a cap 3, a semiconductor device 20 without a trench C but with a cap 3, and a semiconductor device 20 with a trench C and a cap 3. Simulation results are as follows.
(1) For the semiconductor device 20 without the trench C and the cap 3, at a middle point of a surface of the semiconductor device 20, a relative displacement occurred is 1.13 nm, and a stress acting on the surface is 60.3 MPa.
(2) For the semiconductor device 20 without the trench C but with the cap 3, at a middle point of a surface of the semiconductor device 20, a relative displacement occurred is 0.97 nm, and a stress acting on the surface is 39.99 MPa.
(3) For the semiconductor device 20 with the trench C (45 µm) and the cap 3, at a middle point of a surface of the semiconductor device 20, a relative displacement occurred is 0.71 nm, and a stress acting on the surface is 15.87 MPa.

It can be learned from comparison of the foregoing (1), (2), and (3) that, on the surface of the semiconductor device 20 with the trench C (a trench depth is 45 µm) and the cap 3 in (3), the relative displacement occurred is the smallest, and the stress acting on the surface is also the smallest. In other words, the stress acting on the surface of the semiconductor device 20 is effectively reduced by disposing the trench C and the cap 3. In addition, it can be learned from comparison of (1) and (2) that the arrangement of the cap 3 can reduce the stress acting on the surface of the semiconductor device 20; and it can be learned from comparison of (2) and (3) that the arrangement of the trench C can reduce the stress acting on the surface of the semiconductor device 20.

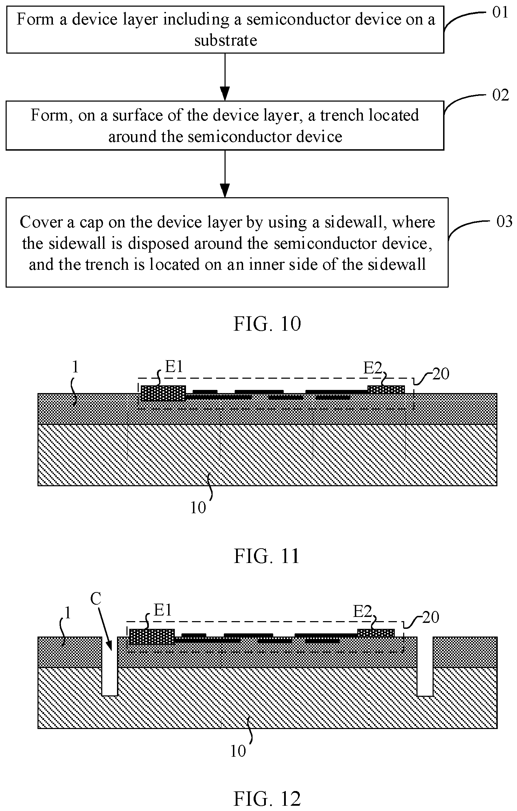

Some embodiments of this application provide a chip manufacturing method. As shown in FIG. 10, the manufacturing method includes the following steps:
Step 01: As shown in FIG. 11, form, on a substrate 10, a device layer 1 including a semiconductor device 20.

By way of example, the foregoing step 01 may include manufacturing a device layer 1 of a plurality of pattern film layers on the substrate 10 (for example, a Si substrate), where the semiconductor device 20 is formed at the plurality of pattern film layers, and the semiconductor device 20 includes electrodes (for example, E1 and E2).

Step 02: As shown in FIG. 12, form, on a surface of the device layer 1, a trench C located around the semiconductor device 20.

By way of example, the foregoing step 02 may include: as shown in FIG. 12, using a reactive ion etching (reactive ion etching, RIE) process to form a trench C disposed around the semiconductor device 20, where a width of the trench C may be 10 µm, and a depth of the trench C may extend into the substrate 10, for example, the depth of the trench C may be 50 µm.

For other related arrangements of the trench C, refer to a corresponding part in the foregoing chip embodiment. Details are not described herein again.

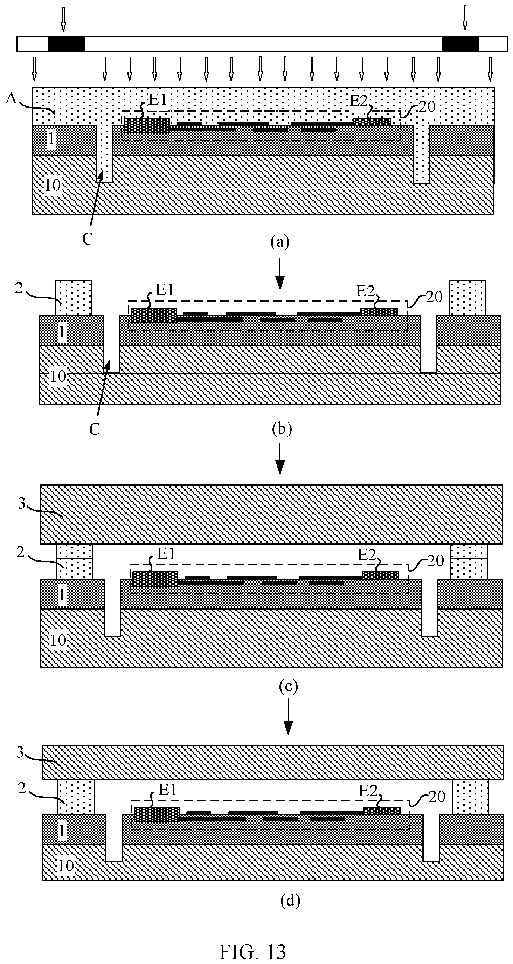

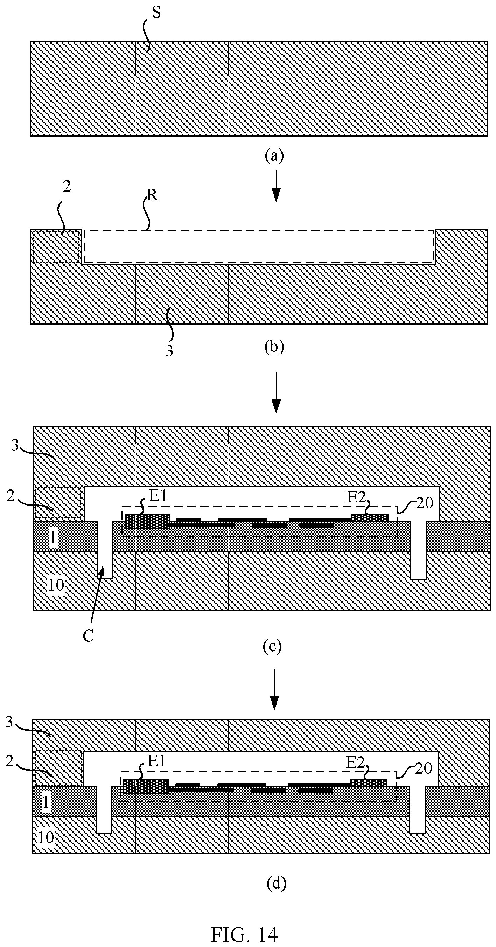

Step 03: As shown in (d) in FIG. 13 or (d) in FIG. 14, cover the cap 3 on the device layer 1 by using a sidewall 2, where the sidewall 2 is disposed around the semiconductor device 20, and the trench C is located on an inner side of the sidewall 2, that is, the trench C is located between the semiconductor device 20 and the sidewall 2.

By way of example, the following provides two specific manufacturing methods of covering the cap 3 on the device layer 1 by using the sidewall 2 in step 03. However, this application is not limited thereto.

In manufacturing method 1, the foregoing step 03 may include the following steps.

Step 3a: As shown in (b) in FIG. 13, form, on the surface of the device layer 1 and on an outer side of the trench C, the sidewall 2 disposed around the semiconductor device 20.

By way of example, step 3a may include: as shown in (a) in FIG. 13, first forming an organic film layer A on the surface of the device layer 1 by using a polymer (for example, a DF3570 negative photoresist), and then patterning the organic film layer A by using a photoetching process (including but not limited to a process such as exposure, development, or curing) to form the sidewall 2 (as shown in (b) in FIG. 13).

Step 3b: As shown in (c) in FIG. 13, cover the cap 3 on the sidewall 2.

By way of example, step 3b may include: covering a silicon chip (that is, 3) on the surface of the sidewall 2, and bonding the silicon chip (3) to the sidewall 2, and then, as shown in (d) in FIG. 13, performing polishing and thinning processing on a lower surface of the Si substrate (10) and an upper surface of the silicon chip (3) by using a chemical mechanical polishing (CMP) process.

In Manufacturing Method 2, the foregoing step 03 may include the following steps.

Step 3c: As shown in (a) and (b) in FIG. 14, dispose a substrate S and form a groove R on a surface of the substrate S, to form an integrated structure including the sidewall 2 and the cap 3, where a groove bottom of the groove R is used as the cap, and a sidewall of the groove R is used as the sidewall 2.

By way of example, step 3c may include: disposing the Si substrate (S), and forming the groove R on the surface of the Si substrate (S) by using an etching process, to form the integrated structure including the sidewall 2 and the cap 3.

Step 3d: As shown in (c) in FIG. 14, cover the integrated structure (that is, the etched Si substrate) including the sidewall 2 and the cap 3 on the device layer 1 by using the sidewall 2.

By way of example, as shown in (c) and (d) in FIG. 14, the etched Si substrate (that is, the integrated structure including the sidewall 2 and the cap 3) and the device layer 1 are bonded by using the sidewall 2, and then, polishing and thinning processing may be performed on a lower surface of the substrate 10 and an upper surface of the cap 3 by using a chemical mechanical polishing process.

In addition, after the cap 3 is covered on the device layer 1, to ensure that the electrodes (E1 and E2) in the semiconductor device 20 can be normally connected to an external device for interconnection and communication, after the foregoing step 03, the chip manufacturing method may further include: as shown in FIG. 8a and FIG. 8b, forming, on the lower surface of the substrate 10 or the upper surface of the cap 3, connecting portions P connected to the electrodes (E1 and E2). The following describes manufacturing of the connecting portion P by using an example.

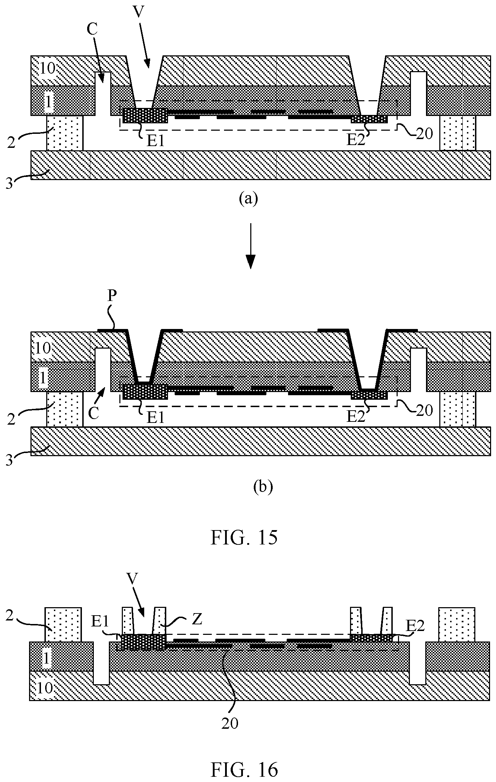

For example, in some possible implementation manners, after the foregoing step 03, the chip manufacturing method may further include: as shown in (a) and (b) in FIG. 15, forming, on a surface of a side that is of the substrate 10 and that faces away from the cap 3, via holes V at positions corresponding to the electrodes (E1 and E2) in the semiconductor device 20, to expose the electrodes (E1 and E2); and then, forming, on the surface of the side that is of the substrate 10 and that faces away from the cap 3, connecting portions P connected to the electrodes (E1 and E2) through the via holes V In other words, the connecting portions P extend from the surface of the substrate 10 to a via hole V area, to contact with the electrodes.

By way of example, an etching process may be used to form, on the surface of the side that is of the substrate 10 and that faces away from the cap, the via holes V at the positions corresponding to the electrodes (E1 and E2) in the semiconductor device 20. Then, the connecting portions P connected to the electrodes through the via holes V are formed by using a process such as coating or etching.

For another example, in some possible implementations, as shown in FIG. 16, when the sidewall 2 is formed in the foregoing step 3a, support posts Z having the via holes V may be formed on the upper surfaces of the electrodes (E1 and E2). After the cap 3 is formed in step 03, as shown in FIG. 8a, new via holes (that is, via holes formed above the electrodes) that are connected to the via holes in the support posts Z may be formed on the cap 3, to expose the electrodes (E1 and E2). Then, the connecting portions P are formed on the surface of the cap 3, and the connecting portions P are connected to the electrodes (E1 and E2) through the via holes located above the electrodes (E1 and E2). In other words, the formed connecting portions P extend from the surface of the cap 3 to the via hole area, to contact with the electrodes.

According to the chip manufacturing method provided in this embodiment of this application, the trench C is manufactured around the semiconductor device 20 at the device layer 1, the sidewall 2 and the cap 3 are formed on an outer side of the semiconductor device 20 and the trench C at the device layer 1, and the semiconductor device 20 and the trench C are disposed in a cavity formed by the sidewall 2 and the cap 3. In this case, a surface of the semiconductor device can be isolated from an external environment by using the cavity formed by the sidewall and the cap, to prevent an external stress from directly acting on the surface of the semiconductor device. A stress transmission path between the outside of the cavity and the semiconductor device can be cut off by using the trench, to prevent the external stress from being transferred to the semiconductor device, so that an impact of the external stress on the semiconductor device is reduced.

For other related content in the foregoing embodiments of the chip manufacturing method, for example, formation and a size of the trench C, refer to the corresponding parts in the foregoing chip structure embodiments. Details are not described herein again. Related structures in the foregoing chip structure embodiments may be correspondingly manufactured by referring to the foregoing embodiments of the chip manufacturing method, or by making a proper adjustment with reference to a related technology. This is not limited in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip, comprising:
a substrate and a device layer disposed on the substrate, wherein the device layer comprises a semiconductor device, and a trench is disposed on a surface of a side that is of the device layer and that faces away from the substrate, and is located around the semiconductor device;
a cap, wherein the cap is located on the side that is of the device layer and that faces away from the substrate; and
a sidewall disposed between the cap and the device layer, wherein the sidewall is disposed around the semiconductor device, and the trench is located on an inner side of the sidewall.

2. The chip according to claim 1, wherein the semiconductor device comprises one or more of a piezoelectric device, a piezoresistive device, or a capacitive sensor device.

3. The chip according to claim 1 or 2, wherein
the trench comprises an annular groove disposed around the semiconductor device.

4. The chip according to claim 1 or 2, wherein
the trench comprises a plurality of grooves dispersedly disposed at spacings around the semiconductor device.

5. The chip according to any one of claims 1 to 4, wherein
a width of the trench is greater than or equal to 0.1 µm.

6. The chip according to any one of claims 1 to 5, wherein
a trench bottom of the trench is located in the substrate.

7. The chip according to any one of claims 1 to 6, wherein
the semiconductor device comprises an electrode;
the chip is provided with a via hole on a side that is of the electrode and that faces away from the cap; and
a connecting portion is disposed on a side that is of the substrate and that faces away from the cap, and the connecting portion is connected to the electrode through the via hole.

8. A chip manufacturing method, comprising:
forming, on a substrate, a device layer comprising a semiconductor device;
forming, on a surface of the device layer, a trench located around the semiconductor device; and
covering a cap on the device layer by using a sidewall, wherein the sidewall is disposed around the semiconductor device, and the trench is located on an inner side of the sidewall.

9. The chip manufacturing method according to claim 8, wherein the chip manufacturing method further comprises:
forming, on a surface of a side that is of the substrate and that faces away from the cap, a via hole corresponding to a position of an electrode in the semiconductor device, and forming a connecting portion connected to the electrode through the via hole.

10. The chip manufacturing method according to claim 8 or 9, wherein
the covering a cap on the device layer by using a sidewall comprises:
forming, on a surface of a side that is of the device layer and that faces away from the substrate, a sidewall that is disposed around the semiconductor device and that is located on an outer side of the trench; and
covering the cap on the sidewall.

11. An electronic device, comprising a printed circuit board and the chip according to any one of claims 1 to 7, wherein the chip is connected to the printed circuit board.
